# EUROPEAN PATENT SPECIFICATION

(11) **EP 2 620 239 B1**
(45) Date of publication and mention of the grant of the patent: **06.09.2017**
(21) Application number: 12152293.2
(22) Date of filing: 24.01.2012
(51) Int. Cl.: B22D 19/00, B22D 19/04, F28D 15/02, F28F 13/18, H01L 23/427, F28F 21/08

(54) **Heat-dissipating module and method for manufacturing the same**
Wärmeableitendes Modul und Verfahren zu seiner Herstellung
Module de dissipation de la chaleur et procédé de fabrication de celui-ci

(43) Date of publication of application: 31.07.2013
(73) Proprietor: Cooler Master Development Corporation, New Taipei City 235, Taiwan (TW)
(72) Inventor: Lin, Chia-Yu, 235 New Taipei City (TW); Liu, Lei-Lei, Hui Zhou City (CN)
(74) Representative: Becker, Eberhard

(56) References cited:
- JP-A- 2004 027 988
- US-A1- 2001 047 590
- US-A1- 2008 062 651
- US-A1- 2008 101 027
- US-A1- 2011 005 727

## Description

### BACKGROUND OF THE INVENTION

### Field of the Invention

The present invention relates to a heat-dissipating module and a method for manufacturing the same. Particularly, the present invention relates to a heat-dissipating module, which is made by using molten metallic materials to cover aluminum-skinned heat pipes via a die casting process and a method for manufacturing the same.

### Description of Prior Art

Heat-conducting elements such as heat pipes are used to dissipate heat or transfer heat. The interior of the heat pipe is made to be vacuumed. A working fluid is filled into the heat pipe to generate a phase change therein. When the working fluid is heated, it evaporates to become vapors, thereby carrying away the heat. Then, the vapor phase of the working fluid condenses to return its liquid phase and to circulate in the heat pipe. In order to manufacture a plate-type heat pipe, conventionally, a plurality of heat pipes is disposed in a solid or hollow metallic plate. Alternatively, a tubular heat pipe is rolled or pressed to form a plate-type heat pipe.

However, the strength of the conventional plate-type heat pipe is insufficient. Further, it is difficult for heat-dissipating elements such as fins to be provided on the conventional plate-type heat pipe. As for the plate-type heat pipe formed by covering heat pipes by a solid or hollow metallic plate, it is an important issue to consider the thermal resistance generated by the gap between the heat pipe and the metallic plate. As for the plate-type heat pipe made by heat pipes penetrating into a solid metallic plate, it is difficult to control the tolerance between the penetrating heat pipe and the metallic plate. If the tolerance is larger, a gap will be formed between the heat pipe and the metallic plate, and thus a heat-conducting medium has to be applied in this gap. If the tolerance is smaller, the penetration of the heat pipe into the metallic plate becomes more difficult. As for the plate-type heat pipe made by embedding heat pipes in a metallic plate, the heat transfer effect between the heat pipe and the metallic plate will be deteriorated because the metallic plate is made of a material (aluminum) different from the material (copper) of the heat pipe.

JP 2004027988 discloses a typical fluid cooler composed of a base, pipes and fins. The pipes made of stainless steel or carbon steel are embedded in the plate made of aluminum die casting without any covers or envelopes. As above mentioned, gaps will occur between the base and the pipes. These gaps will reduce the bonding strength and the efficiency of heat dissipation. Other prior art references such as US 2001/0047590, US 2008/0062651, US 2011/0005727 and US 2008/0101027 also disclose similar structures and they are all silent about avoiding the occurrence of a gap between a pipe and the base.

Among these, US 2001/0047590 A1 discloses a method of manufacturing a heat pipe construction including first providing a tubular pipe with an open end. A thermally conductive material, such as a metallic material or a filled polymer composite material is overmolded over a cast around the tubular pipe. Additional heat dissipating elements, such as insert molded pins, can be provided in the overmolded or cast material to enhance thermal conductivity of the heat sink assembly.

US 2008/0062651 A1 discloses a heat sink comprising a base heat spreader and at least one fin. The at least one fin is connected to the base heat spreader in a normal direction thereof to permit heat transfer from the base heat spreader to the at least one fin.

US 2011/0005727 A1 is related to a manufacturing method of a thermal module. Herein, a copper tube is placed into a mold and a molten metal is injected into the mold to form a substrate, thereby the tube is integrally embedded in the substrate by insert molding technique.

US 2008/0101027 A1 is concerned with a method of manufacturing a heat dissipation device. Herein, a heat sink having a base defining at least one passage through a middle portion thereof is provided. At least one heat pipe is inserted through the at least one passage to reach a position where a middle portion of the at least one heat pipe is located in the at least one passage. Further, an array of fins extends from the top surface of the base.

### SUMMARY OF THE INVENTION

The present invention provides a heat-dissipating module and a method for manufacturing the same. The heat-dissipating module is made by using molten metallic materials to cover at least one aluminum-skinned heat pipe by a die casting process. The aluminum-skinned heat pipe can prevent a gap between itself and a base and improve the bonding strength there between. More specifically, the heat-dissipating module employs the aluminum material as a heat-conducting medium because the aluminum material can generate a good heat-dissipating effect and a better heat transfer effect. On the other hand, the heat-dissipating module of the present invention is chemically stable and thus will not be separated or explored easily. Further, it has a better corrosion resistance.

According to one aspect, the present invention provides a method for manufacturing a heat-dissipating module, including steps of:
a) putting a hollow aluminum tube on a heat pipe to make an aluminum-skinned heat pipe;
b) disposing at least one aluminum-skinned heat pipe into a casting space of a die casting mold, disposing a plurality of fins into the casting space of the die casting mold; and
c) filling aluminum materials in the casting space of the die casting mold to form a heat-dissipating module, wherein the heat-dissipating module includes an aluminum base, at least one aluminum-skinned heat pipe, and a plurality of fins, the aluminum base covers the at least one aluminum-skinned heat pipe and is combined with the fins;
wherein the aluminum materials are melted to cover the at least one aluminum-skinned heat pipe and are combined with the fins by a die casting process, thereby obtaining the heat-dissipating module.

According to another aspect, the present invention provides a heat-dissipating module including an aluminum base, at least one aluminum-skinned heat pipe disposed in the aluminum base, and a plurality of fins erected on the surface of the aluminum base at intervals, wherein the aluminum-skinned heat pipe comprises a heat pipe and an aluminum tube tightly covering the heat pipe.

### BRIEF DESCRIPTION OF DRAWING

FIG. 1 is a perspective view showing the external appearance of the final product according to the present invention;
FIG. 2 is a flow chart showing the steps of the method according to the present invention;
FIG. 3 is a schematic view showing the step S1 in the method of the present invention;
FIG. 4 is a schematic view showing that an aluminum-skinned heat pipe is subjected to a draw-forming process in the step S1 of the method according to the present invention;
FIG. 5 is a schematic view showing the state of the aluminum-skinned heat pipe before and after a draw-forming process in the step S1 of the method according to the present invention;
FIG. 6 is a schematic view showing that an aluminum-skinned heat pipe is subjected to a draw-forming process and both ends thereof are sealed in the step S1 of the method according to the present invention;
FIG. 7 is a schematic view showing the step S2 in the method of the present invention;
FIG. 8 is a schematic view showing the step S3 in the method of the present invention; and
FIG. 9 is a cross-sectional view showing the internal construction of the final product according to the present invention.

### DETAILED DESCRIPTION OF THE INVENTION

In order to make the Examiner to better understand the characteristics and technical contents of the present invention, a detailed description will be made with reference to the accompanying drawings. However, it is noteworthy to point out that the drawings is provided for the illustration purpose only, but not intended for limiting the scope of the present invention.

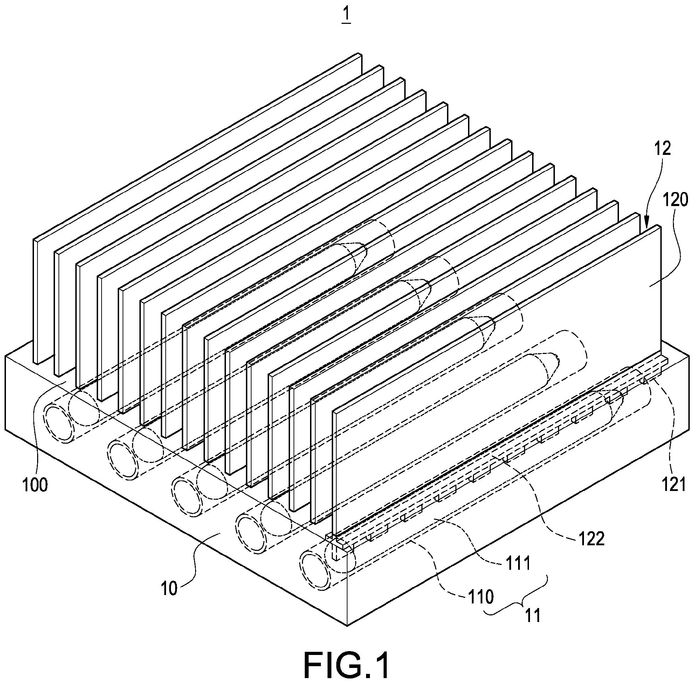

Please refer to FIG. 1, which is a perspective view showing the external appearance of the final product according to the present invention. The present invention provides a heat-dissipating module and a method for manufacturing the same. The interior of the heat-dissipating module 1 is embedded with at least one aluminum-skinned heat pipe 11. Each aluminum-skinned heat pipe 11 comprises a hollow aluminum tube 110 and a heat pipe 111. The aluminum tube 110 is put on the heat pipe 111 to form the aluminum-skinned heat pipe 11. The heat-dissipating module 1 includes an aluminum base 10, at least one aluminum-skinned heat pipe 11, and a plurality of fins 12, wherein the aluminum-skinned heat pipes 11 are provided in the aluminum base 10 at intervals.

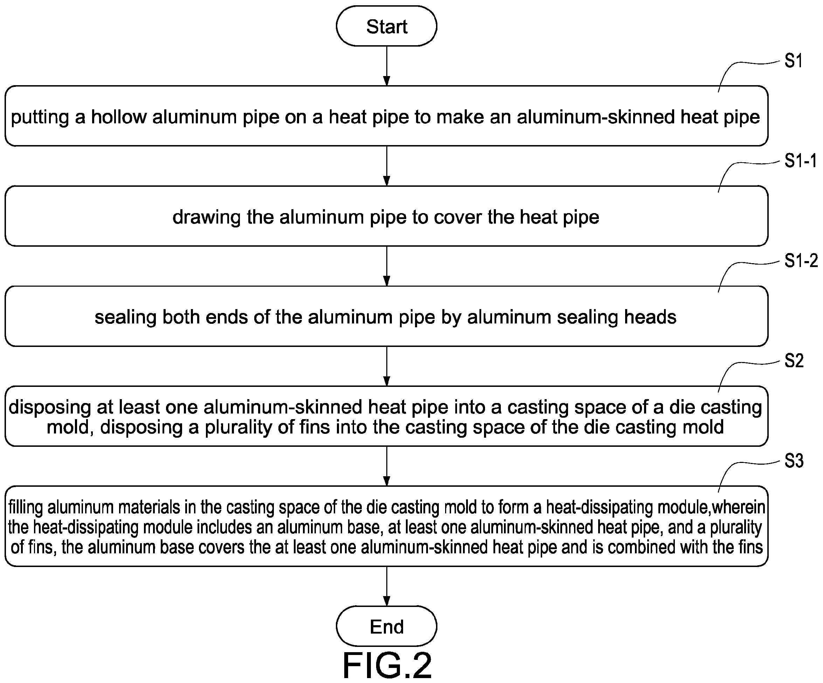

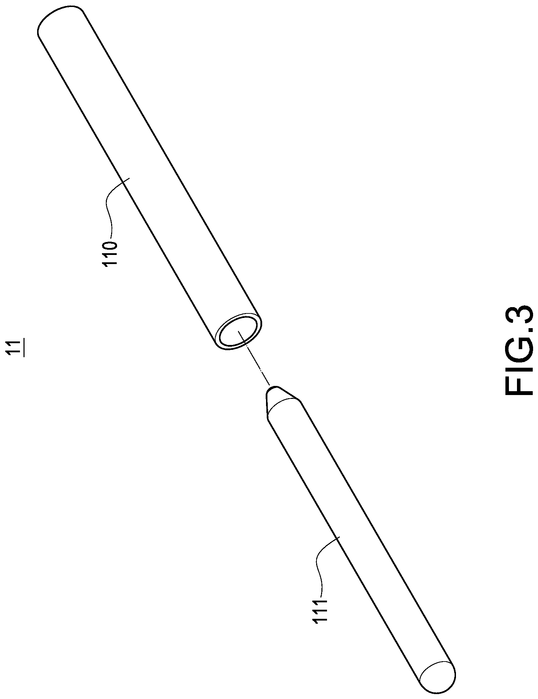

Please also refer to FIGS. 2 and 3. The method of the present invention has steps as follows. First, in the step S1 shown in FIG. 2, at least one heat pipe 111 and a hollow aluminum tube 110 corresponding to the heat pipe 111 are prepared. The inner diameter of each aluminum tube 110 is slightly larger than the outer diameter of the corresponding heat pipe 111, so that the aluminum tube 110 can be put on the heat pipe 111 to form the aluminum-skinned heat pipe 11. The aluminum tube 110 may be made of aluminum-based metals or alloys thereof. Alternatively, the aluminum tube 110 may be made of the same material as that of the aluminum base 10.

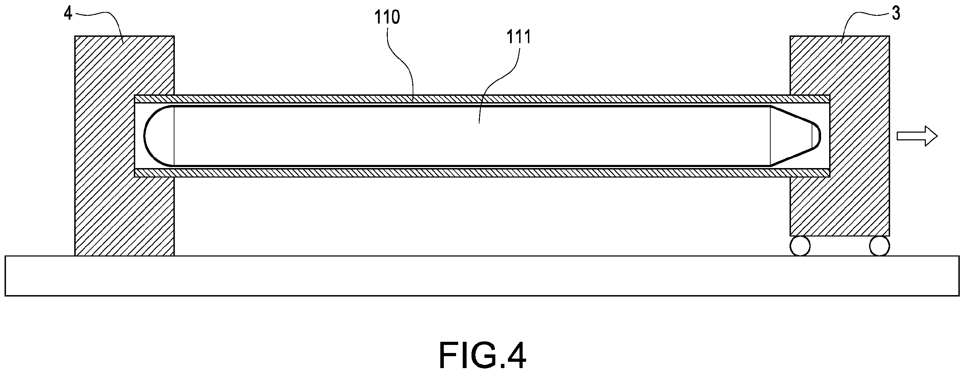

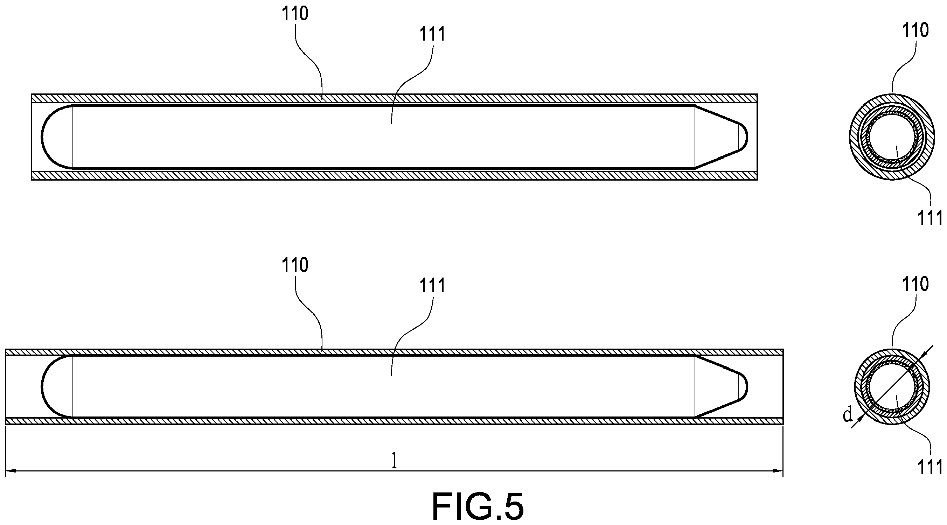

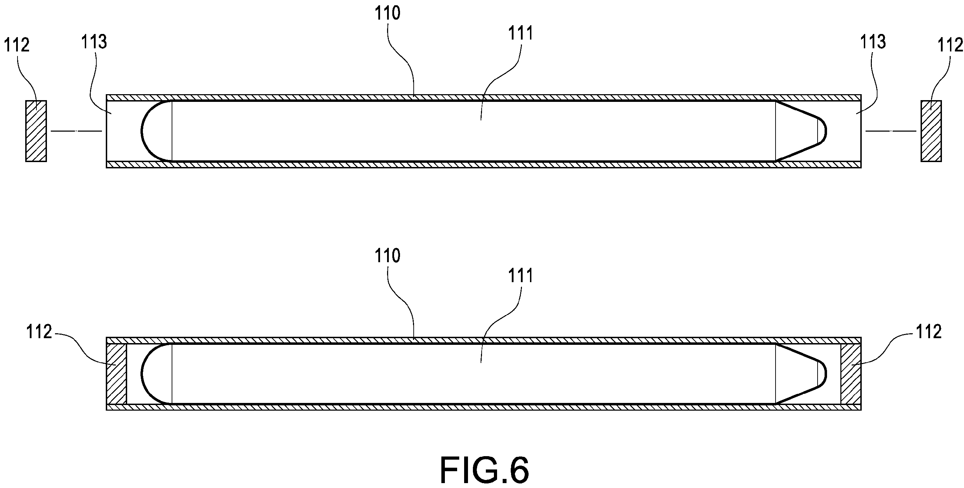

Please also refer to FIGS. 3 to 6. In the steps S1-1 to S1-2 shown in FIG. 2 of the present embodiment, the aluminum-skinned heat pipe 11 can be made by the following process. First, one end of the aluminum tube 110 is fixed onto a mounting base 3, and the other end of the aluminum tube 110 is fixed to a movable stage 4. In the beginning, the movable stage 4 moves in a direction away from the mounting base 3, thereby drawing the aluminum tube 110. In this way, the length 1 of the aluminum tube 110 is increased, and the diameter d of the aluminum tube 110 is reduced, so that the aluminum tube 110 can cover the heat pipe 111 to form the aluminum-skinned heat pipe 11.

After the drawing process, the aluminum-skinned heat pipe 11 is taken off from the mounting base 3 and the movable stage 4. Then, both ends of the aluminum-skinned heat pipe 11 are sealed. More specifically, two aluminum sealing heads 112 are used to seal two ends 113 of the aluminum tube 110, so that the heat pipe 111 is completely covered by the aluminum tube 110. The aluminum sealing head 112 may be made of the same material as that of the aluminum tube 110 or the aluminum base 10.

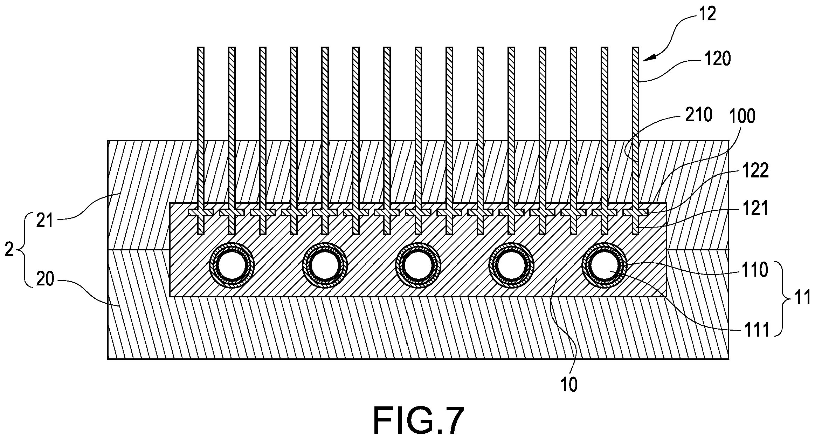

Next, please also refer to FIG. 7. In the step S2 shown in FIG. 2, the at least one aluminum-skinned heat pipe 11 is disposed in a die casting mold 2. In the present embodiment, the fins 12 are disposed into the die casting mold 2. The die casting mold 2 includes a first mold part 20 and a second mold part 21. After the first mold part 20 and the second mold part 21 are brought into tight contact with each other, a casting space 22 is formed in the die casting mold 2. In the die casting space 22, the aluminum base 10 of the heat-dissipating module 1 is formed. Further, a plurality of through troughs 210 is formed in the second mold part 21 in communication with the casting space 22, so that the fins 12 can be disposed through the through troughs 210 respectively. A portion of the fins 12 is exposed to the outside of the second mold part 21, and a portion of the fins 12 extends into the casting space 22. In the present embodiment, although the first mold part 20 is located below the second mold part 21, the first mold part 20 may be located above the second mold part 21.

According to the above, each fin 12 is made of materials of good heat-dissipating property such as aluminum or copper. Each fin 12 may be made by a punching process or a pressing process to form a sheet-like heat-dissipating portion 120 and a connecting portion 121 formed at a distal end of the heat-dissipating portion 120. One side or both sides of the connecting portion 121 is provided with laterally-protruding insertion portions 122, thereby increasing the combination strength of the fins 12 with the aluminum base 10 of the heat-dissipating module 1.

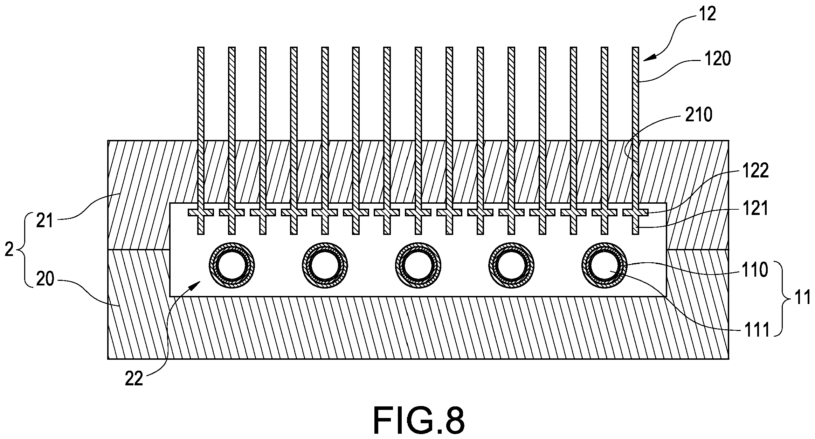

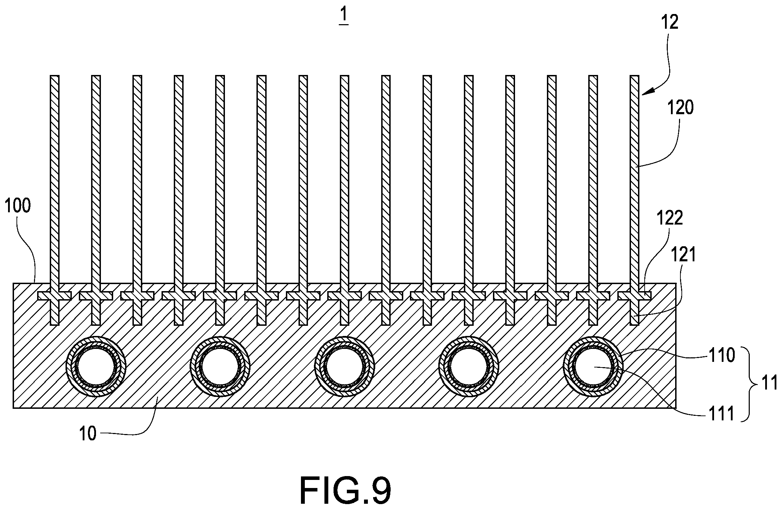

Finally, please also refer to FIG. 8. In the step S3 shown in FIG. 2, the aluminum material is filled in the casting space 22 of the die casting mold 2, thereby forming the aluminum base 10 in the casting space 22. In this way, the aluminum-skinned heat pipe 11 is covered inside the aluminum base 10. The fins 12 and the aluminum-skinned heat pipe 11 are combined with the aluminum base 10. The connecting portions 121 of the fins 12 are connected into the aluminum base 10 to erect on one surface 100 of the aluminum base 10 at intervals. At this time, when the aluminum base 10 is formed in the casting mold 2, since the molten aluminum material filled in the casting space 22 makes the aluminum tube 110 to tightly cover the corresponding heat pipe 111, thereby forming the heat-dissipating module 1 as shown in FIG. 9. In other words, the heat-dissipating module 1 is formed by using molten metal materials to cover at least one aluminum-skinned heat pipe 11 by a die casting process.

In the thus-formed heat-dissipating module 1 made by covering the aluminum-skinned heat pipe 11 with molten metallic materials, since the aluminum tube 110 acts as an aluminum skin to cover the heat pipe 111, a good heat-dissipating effect and a better heat transfer effect can be achieved between the aluminum-skinned heat pipe 11 and the aluminum base 10. On the other hand, since the heat-dissipating module 1 is made by using a die casting process to cover the aluminum-skinned heat pipe 11 with molten metallic materials, the present invention has a better corrosion resistance.

Therefore, with the above method, the heat-dissipating module of the present invention can be obtained.

## Claims

1. A method for manufacturing a heat-dissipating module, including steps of:
a) putting a hollow aluminum tube (110) on a corresponding heat pipe (111) to form an aluminum-skinned heat pipe (11);
b) disposing at least one aluminum-skinned heat pipe (11) into a casting space (22) of a die casting mold (2), disposing a plurality of fins (12) in the casting space (22) of the die casting mold (2); and
c) filling aluminum materials into the casting space (22) of the die casting mold (2) to form a heat-dissipating module (1), wherein the heat-dissipating module (1) comprises an aluminum base (10), at least one aluminum-skinned heat pipe (11), and a plurality of fins (12), and the aluminum base (10) covers the at least one aluminum-skinned heat pipe (11) and is combined with the fins (12).

2. The method according to claim 1, wherein the aluminum-skinned heat pipe (11) in the step a) is made by stretching the hollow aluminum tube (110) to cover the heat pipe (111).

3. The method according to claim 2, further including a step of sealing both ends (113) of the hollow aluminum tube (110) with two aluminum sealing heads (112).

4. The method according to claim 1, wherein the die casting mold (2) in the step b) comprises a first mold part (20) and a second mold part (21), and the first mold part (20) and the second mold part (21) are brought into tight contact with each other to form the casting space (22) in which the aluminum base (10) is formed.

5. The method according to claim 4, wherein the first mold part (20) is located below the second mold part (21).

6. The method according to claim 4, wherein the first mold part (20) is located above the second mold part (21).

7. The method according to claim 4, wherein the second mold part (21) is provided with a plurality of through troughs (210) in communication with the casting space (22), and the fins (12) are disposed through the through troughs (210) respectively.

8. A heat-dissipating module, including:
- an aluminum base (10) having a surface (100);
- at least one aluminum-skinned heat pipe (11) disposed in the aluminum base (10); and
- a plurality of fins (12) erecting on the surface (100) of the aluminum base (10) at intervals;
- **characterized in that** the aluminum-skinned heat pipe (11) comprises a heat pipe (111) and an aluminum tube (110) covering the heat pipe (111).

9. The heat-dissipating module according to claim 8, wherein the aluminum base (10) and the aluminum tube (110) are made of aluminum-based metals or alloys thereof.

10. The heat-dissipating module according to claim 8, wherein the aluminum-skinned heat pipes (11) are disposed in the aluminum base (10) at intervals.

11. The heat-dissipating module according to claim 8, wherein the aluminum-skinned heat pipe (11) is sealed by aluminum sealing heads (112) at both ends (113) of the aluminum tube (110).

12. The heat-dissipating module according to claim 11, wherein the aluminum sealing heads (112) are made of the same material as that of the aluminum tube (110) or the aluminum base (10).

13. The heat-dissipating module according to claim 8, wherein each fin (12) has a heat-dissipating portion (120) and a connecting portion (121) formed at a distal end of the heat-dissipating portion (120), and the connecting portion (121) is connected into the aluminum base (10).

14. The heat-dissipating module according to claim 13, wherein the connecting portion (121) of each fin (12) is provided with laterally-protruding insertion portions (122).

## Patentansprüche

1. Verfahren zur Herstellung eines Kühlmoduls, die Schritte enthaltend:
a) Aufstecken einer holen Aluminiumröhre (110) auf ein entsprechendes Wärmerohr (111), um ein aluminiumummanteltes Wärmerohr (11) zu bilden;
b) Anordnen wenigstens eines aluminiumummantelten Wärmerohrs (11) in einem Gussraum (22) einer Druckgussform (2), Anordnen einer Vielzahl von Lamellen (12) in dem Gussraum (22) der Druckgussform (2); und
c) Füllen von Aluminiummaterial in den Gussraum (22) der Druckgussform (2), um ein Kühlmodul (1) zu bilden, wobei das Kühlmodul (1) eine Aluminiumbasis (10), wenigstens ein aluminiumummanteltes Wärmerohr (11) und eine Vielzahl von Lamellen (12) umfasst und wobei die Aluminiumbasis (10) das wenigstens eine aluminiumummantelte Wärmerohr (11) bedeckt und mit den Lamellen (12) kombiniert ist.

2. Verfahren gemäß Anspruch 1, wobei das aluminiumummantelte Wärmerohr (11) in dem Schritt a) durch Strecken der holen Aluminiumröhre (110) hergestellt ist, um das Wärmerohr (111) zu bedecken.

3. Verfahren gemäß Anspruch 2, weiterhin enthaltend einen Schritt des Abdichtens beider Enden (113) der holen Aluminiumröhre (110) mit zwei Aluminiumabdichtköpfen (112).

4. Verfahren gemäß Anspruch 1, wobei die Gussform (2) in dem Schritt b) einen ersten Formteil (20) und einen zweiten Formteil (21) umfasst und wobei der erste Formteil (20) und der zweite Formteil (21) in engen Kontakt miteinander gebracht werden, um den Gussraum (22) zu bilden, in dem die Aluminiumbasis (10) gebildet wird.

5. Verfahren gemäß Anspruch 4, wobei der erste Formteil (20) sich unterhalb des zweiten Formteils (21) befindet.

6. Verfahren gemäß Anspruch 4, wobei der erste Formteil (20) sich oberhalb des zweiten Formteils (21) befindet.

7. Verfahren gemäß Anspruch 4, wobei der zweite Formteil (21) mit einer Vielzahl von Durchgangslöchern (210) ausgestattet ist, die in Verbindung mit dem Gussraum (22) stehen, und wobei die Lamellen (12) jeweils durch die Durchgangslöcher (210) angeordnet sind.

8. Kühlmodul, enthaltend:
- eine Aluminiumbasis (10) mit einer Oberfläche (100);
- wenigstens ein aluminiumummanteltes Wärmerohr (11), das in der Aluminiumbasis (10) angeordnet ist; und
- eine Vielzahl von Lamellen (12), die in Abständen an der Oberfläche (100) der Aluminiumbasis (10) aufgestellt sind;
- **dadurch gekennzeichnet, dass** das aluminiumummantelte Wärmerohr (11) ein Wärmerohr (111) und eine Aluminiumröhre (110) umfasst, die das Wärmerohr (111) abdeckt.

9. Kühlmodul gemäß Anspruch 8, wobei die Aluminiumbasis (10) und die Aluminiumröhre (110) aus Metallen auf Aluminiumbasis oder Legierungen davon hergestellt sind.

10. Kühlmodul gemäß Anspruch 8, wobei die aluminiumummantelten Wärmerohre (11) in Abständen in der Aluminiumbasis (10) angeordnet sind.

11. Kühlmodul gemäß Anspruch 8, wobei das aluminiumummantelte Wärmerohr (11) durch Aluminiumabdichtköpfe (112) an beiden Enden (113) der Aluminiumröhre (110) abgedichtet ist.

12. Kühlmodul gemäß Anspruch 11, wobei die Aluminiumabdichtköpfe (112) aus dem gleichen Material gefertigt sind, wie das der Aluminiumröhre (110) oder der Aluminiumbasis (10).

13. Kühlmodul gemäß Anspruch 8, wobei jede Lamelle (12) einen Kühlabschnitt (120) und eine Verbindungsabschnitt (121), der am entfernten Ende des Kühlabschnitts (120) angeordnet ist, aufweist, und wobei der Verbindungsabschnitt (121) in der Aluminiumbasis (10) verbunden ist.

14. Kühlmodul gemäß Anspruch 13, wobei der Verbindungsabschnitt (121) jeder Lamelle mit seitlich hervorstehenden Einsetzabschnitten (122) ausgestattet ist.

## Revendications

1. Procédé de fabrication d'un module de dissipation thermique, incluant les étapes consistant à :
a) placer un tuyau d'aluminium creux (110) sur un caloduc correspondant (111) afin de former un caloduc à revêtement d'aluminium (11) ;
b) disposer au moins un caloduc à revêtement d'aluminium (11) dans un espace de coulée (22) d'un moule de coulée sous pression (2), disposer une pluralité d'ailettes (12) dans l'espace de coulée (22) du moule de coulée sous pression (2) ; et
c) remplir des matériaux d'aluminium dans l'espace de coulée (22) du moule de coulée sous pression (2) afin de former un module de dissipation thermique (1), dans lequel le module de dissipation thermique (1) comprend une base d'aluminium (10), au moins un caloduc à revêtement d'aluminium (11) et une pluralité d'ailettes (12) et la base d'aluminium (10) recouvre au moins un caloduc à revêtement d'aluminium (11) et est combiné avec les ailettes (12).

2. Procédé selon la revendication 1, dans lequel le caloduc à revêtement d'aluminium (11) dans l'étape a) est fabriqué en étirant le tuyau d'aluminium creux (110) pour recouvrir le caloduc (111).

3. Procédé selon la revendication 2, incluant en outre une étape de scellement étanche des deux extrémités (113) du tuyau d'aluminium creux (110) avec deux têtes de scellement étanche en aluminium (112).

4. Procédé selon la revendication 1, dans lequel le moule de coulée sous pression (2) dans l'étape b) comprend une première partie de moule (20) et une seconde partie de moule (21), et la première partie de moule (20) et la seconde partie de moule (21) sont amenées en contact étroit l'une avec l'autre pour former l'espace de coulée (22) dans lequel la base d'aluminium (10) est formée.

5. Procédé selon la revendication 4, dans lequel la première partie de moule (20) est située au-dessous de la seconde partie de moule (21).

6. Procédé selon la revendication 4, dans lequel la première partie de moule (20) est située au-dessus de la seconde partie de moule (21).

7. Procédé selon la revendication 4, dans lequel la seconde partie de moule (21) est pourvue d'une pluralité d'alésages traversants (210) en communication avec l'espace de coulée (22) et les ailettes (12) sont disposées à travers les alésages traversants (210) respectivement.

8. Module de dissipation thermique, incluant :
- une base d'aluminium (10) ayant une surface (100) ;
- au moins un caloduc à revêtement thermique (11) disposé dans la base d'aluminium (10) ; et
- une pluralité d'ailettes (12) se dressant sur la surface (100) de la base d'aluminium (10) à intervalles ;
- **caractérisé en ce que** le caloduc à revêtement d'aluminium (11) comprend un caloduc (111) et un tuyau d'aluminium (110) recouvrant le caloduc (111).

9. Module de dissipation thermique selon la revendication 8, dans lequel la base d'aluminium (10) et le tuyau d'aluminium (110) sont fabriqués en métaux à base d'aluminium ou des alliages de ces derniers.

10. Module de dissipation thermique selon la revendication 8, dans lequel les caloducs à revêtement d'aluminium (11) sont disposés dans la base d'aluminium (10) à intervalles.

11. Module de dissipation thermique selon la revendication 8, dans lequel le caloduc à revêtement thermique (11) est scellé de manière étanche par les têtes de scellement étanche en aluminium (112) aux deux extrémités (113) du tuyau d'aluminium (110).

12. Module de dissipation thermique selon la revendication 11, dans lequel les têtes de scellement étanche an aluminium (112) sont fabriquées dans le même matériau que celui du tuyau d'aluminium (110) ou la base d'aluminium (10).

13. Module de dissipation thermique selon la revendication 8, dans lequel chaque ailette (12) a une portion de dissipation thermique (120) et une portion de raccordement (121) formée à une extrémité distale de la portion de dissipation thermique (120) et la portion de raccordement (121) est raccordée dans la base d'aluminium (10).

14. Module de dissipation thermique selon la revendication 13, dans lequel la portion de raccordement (121) de chaque ailette (12) est pourvue de portions d'insertion dépassant latéralement (122).
